**Europäisches Patentamt**

**European Patent Office**

**Office européen des brevets**

(19)

(11) Publication number : **0 419 098 B1**

(12) # EUROPEAN PATENT SPECIFICATION

(45) Date of publication of patent specification :
09.11.94 Bulletin 94/45

(51) Int. Cl.⁵ : **H01L 41/20**

(21) Application number : **90309824.2**

(22) Date of filing : **07.09.90**

(54) **Cobalt-iron magnetostrictive alloys, and their use in products.**

(30) Priority : **08.09.89 JP 233594/89**

(43) Date of publication of application :
**27.03.91 Bulletin 91/13**

(45) Publication of the grant of the patent :
**09.11.94 Bulletin 94/45**

(84) Designated Contracting States :
**DE SE**

(56) References cited :
**US-A- 4 308 474**
**US-A- 4 374 665**
**US-A- 4 378 258**

(73) Proprietor : **KABUSHIKI KAISHA TOSHIBA**
**72, Horikawa-cho**
**Saiwai-ku**
**Kawasaki-shi Kanagawa-ken 210 (JP)**

(72) Inventor : **Sahashi, Masashi, c/o Intellectual**
**Property Div.**
**Kabushiki Kaisha Toshiba,**
**1-1, Shibaura 1-chome**
**Minato-ku, Tokyo (JP)**
Inventor : **Kobayashi, Tadahiko, c/o**
**Intellectual Property Div**
**Kabushiki Kaisha Toshiba,**
**1-1, Shibaura 1-chome**
**Minato-ku, Tokyo (JP)**

(74) Representative : **BATCHELLOR, KIRK & CO.**
**2 Pear Tree Court**
**Farringdon Road**
**London EC1R 0DS (GB)**

## Description

This invention generally relates to magnetostrictive alloys, such as supermagnetostrictive alloys, adapted for forming magnetostrictive elements useful in devices which convert between magnetic displacement and mechanical displacement. More particularly, it is directed to (selected group 3 metal(s))-cobalt, such as rare earth-cobalt, supermagnetostrictive alloys suitable for use in a wide temperature range including low temperatures (room temperature or below).

It is known that magnetostriction, which is a strain caused when a magnetic field is applied externally to ferromagnetic substances such as Ni alloys, Fe-Co alloys, and ferrite, is applied to various devices such as, for example, magnetostrictive filters, magnetostrictive sensors, supersonic delay lines, and magnetostrictive oscillators.

Recent developments in the field of instrumentation engineering and precision machinery require fine displacement control (of the order of microns) and thus demand that displacement drive units for such fine displacement control be developed. As a means for a drive mechanism of such a drive unit, attention has been given to the use of devices which convert between magnetic and mechanical displacements by the magnetostriction properties of a magnetostrictive substance.

However, conventionally known magnetostrictive materials (magnetostrictive substances) generally provide only a small displacement in absolute terms, and are not considered fully practicable. Conventional magnetostrictive materials may not be satisfactory not only in terms of absolute drive displacement but also in terms of precision control wherein displacement control drive means having accuracy of the order of microns is required.

On the other hand, as highly magnetostrictive materials, rare earth magnetostrictive alloys are disclosed, e.g., in the specification patent US-A- 4,378,258 and Japanese Patent Examined Publication No. 33892/1987. However, known rare earth-iron alloys are not satisfactory in that their magnetostriction is reduced at a low temperature range, nor are known rare earth-cobalt alloys suitable for use in a high temperature environment because their Curie temperature is low. Accordingly rare earth magnetostrictive alloys are, in general, unsatisfactory as displacement control drive means that must be able to perform desired functions accurately in the order of microns in a wide range of temperatures from low (at room temperature) to high temperatures.

As an exception among rare earth-iron alloys of the above type, $TbFe_2$, whose easy axis of magnetization is <111> oriented, is known to exhibit and maintain excellent magnetostriction at low temperatures (room temperature or lower). However, $TbFe_2$ is not only inferior in oxidation resistance and sinterability but also disadvantageous in that it increases both the size and cost of the device as it requires a relatively large magnetic field in order to obtain a predetermined magnetostriction. Further, $Tb(Fe_{0.8}Co_{0.2})_2$, obtained by replacing part of Fe by Co is also known from US-A- 4 378 258. This is a modification of $TbFe_2$ with oxidation resistance and other properties improved and its easy axis of magnetization is also <111> oriented. However, $Tb(Fe_{0.8}Co_{0.2})_2$ is costly as a material and thus not economically advantageous as a general purpose material except for special applications.

It is, therefore, an object of this invention to provide iron-cobalt magnetostrictive alloys that can not only exhibit and maintain excellent magnetostriction, such as supermagnetostriction, over a wide temperature range but which are economically advantageous and thus may have more general purpose application.

Another object of this invention is to provide a group 3 metal-(such as a rare earth)-cobalt supermagnetostrictive alloy suitable for use in displacement control drive means capable of functioning accurately in the order of microns.

The group 3 notation used herein is derived from the Periodic Table of the elements, IUPAC recommended group notation from 1986.

A rare earth-cobalt supermagnetostrictive alloy according to this invention has a composition represented by the general formula, in atomic proportions:

$$(1) \qquad R\,(Co_{1-x}Fe_x)_z$$

wherein $0.001 \leqq x \leqq 0.8$ and $0.2 \leqq z \leqq 15$ and R is at least one element selected from the group consisting of Sc, Y, La, Ce, Pr, Nd, Pm, Sm, Eu, Gd, Tb, Dy, Ho, Er, Tm, Yb, and Lu and consists essentially of a cubic system whose easy axis of magnetization is generally <100> or <110> oriented.

In order that the invention may be illustrated and readily carried into effect, non-limiting embodiments thereof will now be described by way of example only and with reference to the accompanying drawing, wherein:

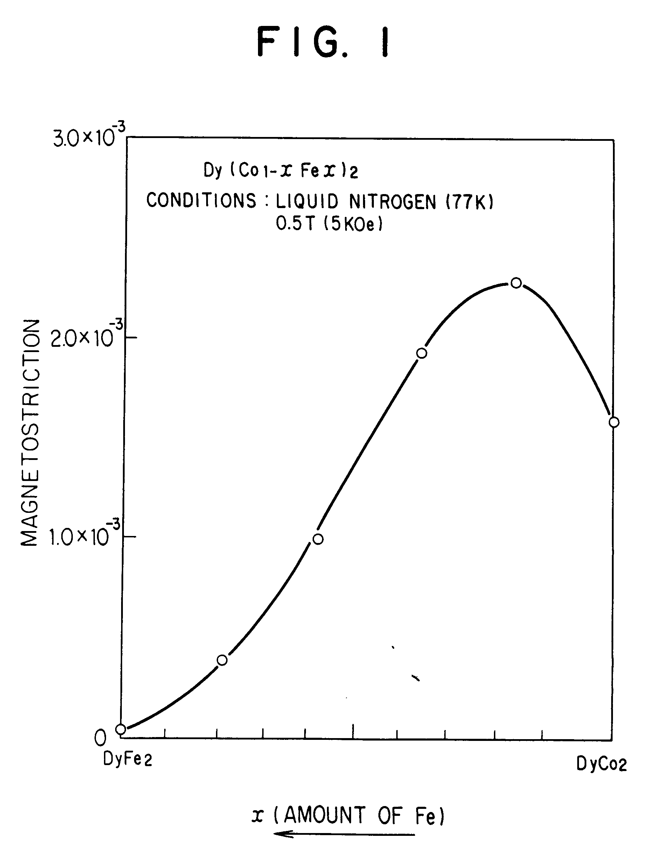

Fig. 1 is a diagram illustrating magnetostriction of group 3-such as rare earth-cobalt supermagnetostrictive alloys according to this invention.

The present inventors investigated Tb-Dy-Fe cubic system Laves type intermetallic compounds that have been disclosed in the above-mentioned specification of US-A- 4378257 and the like as having excellent magnetostriction and having the easy axis of magnetization in <111> direction. Due regard was taken of the conventionally accepted opinion that when an Fe magnetostrictive alloy has its easy axis of magnetization in <100> direction, its magnetostriction is small. Taking the Laves type intermetallic compounds of Dy and Fe, particularly, $DyFe_2$, for research, the present inventors investigated alloys in which Fe or some Fe was replaced by Co. As a result, as far as the easy axis of magnetization is generally <100>, <110>, or likely oriented, the following observations were unexpectedly found, and the present invention is based thereon.

(1) Supermagnetostriction characterized by a value far greater than that of a known rare earth-iron substance was exhibited.

(2) Supermagnetostriction was exhibited in a magnetic field as low as 0.2 T (tesla) (2 kOe).

(3) Supermagnetostriction better than that exhibited by a known binary rare earth-cobalt intermetallic compounds was exhibited.

(4) Satisfactory supermagnetostriction was exhibited at cryogenic temperatures from 4.2 K to liquid nitrogen temperature.

(5) Sinterability was good enough to allow thin film deposition and arbitrary forming to be performed.

In the group 3- iron-cobalt supermagnetostrictive alloys according to this invention, as represented by the general formula, in atomic proportions, $R (Co_{1-x}Fe_x)_z$, z representing the atomic proportion of the cobalt-iron component and should be selected such that $0.2 \leqq z \leqq 15$

or, preferably, $z \leqq 10$ or, more preferably, $1.5 \leqq z \leqq 5$, because it can be difficult to obtain supermagnetostriction of $10^{-4}$ or more with $z > 15$ and no effect of replacement of iron may be exhibited with $0.2 > z$. Cubic systems wherein $z = 2$, $z = 23/6$, or $z = 13$ can exhibit satisfactory magnetostriction and are thus preferred.

If the amount of iron, x, is smaller than 0.001, the effect of replacement may not be exhibited. If $x > 0.8$, the iron, which is a non-group 3 transition metal, plays an influential role in determining its magnetostriction, and may induce significant reduction in the magnetostriction with decreasing temperatures, thus no longer being practicable. Thus, the amount of iron, x, in alloys of the invention should be within the range of 0.001-0.8, or 0.01 to 0.8 preferably, 0.1-0.5.

## Example 1

The elements Tb, Dy, Nd, Gd, Sm, Pr, Ce, La, Y, Er, Co, and Fe were respectively selected and weighed at a composition ratio (atomic proportions) as shown in Table 1 and then subjected to an arc casting process to prepare 13 types of rare earth magnetostrictive alloys including a comparative example. The arc casting process was performed in an inert gas atmosphere such as an argon gas atmosphere using a copper container.

The prepared rare earth magnetostrictive alloys were then subjected to a thermal process for homogenization at 900°C for 7 days (168 hours). Each sample was cut into a test piece of 10 x 10 x 5 mm.

Each test piece thus obtained was evaluated for magnetostriction at both room temperature (RT) and liquid nitrogen temperature (N₂) using a strain gauge. The result is also shown in Table 1.

The magnetostriction was measured in a magnetic field of 0.2 Tesla (2 kOe) produced by an opposite pole type electromagnet and the magnetostriction values are shown with that of $DyFe_2$, a comparative example, being 1 at room temperature for comparison.

As is apparent from Table 1, the composite iron-cobalt supermagnetostrictive alloys according to this invention demonstrate very large magnetostriction not only at room temperature but also at liquid nitrogen temperature in a low magnetic field. This establishes that the supermagnetostrictive alloys according to the present invention exhibit excellent magnetostriction over a wide temperature range from room temperature to liquid nitrogen temperature. The exhibited values can even be improved about 5-50% by controlling the content of impurities such as $O_2$, N, and Ca within the range of 10-1000 ppm.

Further, the alloys obtained by setting z in $Dy(Co_{1-x}Fe_x)_z$ to 23/6 (example 11) and 13 (example 12) provided satisfactory magnetostrictions, similar to other examples (1-10), at room temperature and liquid nitrogen temperature.

Table 1

| Sample No. | Alloy composition (at%) | Magnetostriction | | Easy axis of magnetization |
|---|---|---|---|---|
| | | (RT) | $(N_2)$ | |
| 1 | $Dy (Co_{0.6}Fe_{0.4})_2$ | 10 | 100 | ~ <100> |
| 2 | $Dy (Co_{0.4}Fe_{0.6})_3$ | 9 | 85 | |
| 3 | $Nd (Co_{0.7}Fe_{0.3})_5$ | 12 | 120 | |
| 4 | $Gd (Co_{0.8}Fe_{0.2})_2$ | 5 | 50 | ~ <100> |
| 5 | $Sm (Co_{0.8}Fe_{0.2})_7$ | 3 | 20 | |
| 6 | $Pr (Co_{0.6}Fe_{0.4})_3$ | 5 | 80 | |
| 7 | $Ce (Co_{0.8}Fe_{0.2})_2$ | 5 | 45 | ~ <100> |
| 8 | $La (Co_{0.8}Fe_{0.2})_2$ | 4 | 40 | ~ <100> |
| 9 | $Y (Co_{0.5}Fe_{0.5})_2$ | | 45 | ~ <100> |
| 10 | $Er (Co_{0.8}Fe_{0.2})_2$ | 12 | 150 | ~ <100> |
| 11 | $Dy (Co_{0.6}Fe_{0.4})_{2.5}$ | 9 | 90 | |
| 12 | $Dy (Co_{0.6}Fe_{0.4})_{13}$ | 7 | 60 | |
| 13 | $(Gd_{0.4}Dy_{0.6})(Co_{0.8}Fe_{0.2})_2$ | 15 | 120 | ~ <100> |
| Comparative example | $DyFe_2$ | 1 | 0.3 | ~ <100> |
| | $(Tb_{0.3}Dy_{0.7}) Fe_2$ | 10 | 1 | ~ <111> |

The symbol "~" means "generally or substantially" in Table 1.

Example 2

The elements Dy, Co, and Fe were respectively selected and weighed at a predetermined composition ratio (atomic proportions) and then subjected to an arc casting process in a manner similar to Example 1, to prepare 6 types of rare earth magnetostrictive alloys including a comparative example. The prepared rare earth magnetostrictive alloys were then subjected to a thermal process for homogenization at 900°C for 7 days (168 hours). Each sample was cut into a test piece of 10 x 10 x 5 mm.

Each test piece thus obtained was evaluated for magnetostriction at liquid nitrogen temperature (77 K) using the strain gauge. The result is shown in Fig. 1.

The magnetostriction was measured in a magnetic field of 0.5 Tesla (5 kOe) produced by an opposite pole type electromagnet.

The alloys obtained by setting x in $Dy(Co_{1-x}Fe_x)_z$ to from 0.6 to 0.8 exhibited magnetostriction values lower than that of the $DyCo_2$ but their resistance to oxidation was acceptable. Thus, when used as a magnetostrictive oscillator for superconductive magnet actuators, they will exhibit excellent stability and reliability compared to a $DyCo_2$ magnetostrictive oscillator.

As is understood from the above description, the group 3 metal- e.g. rare earth-cobalt supermagnetostrictive alloys according to this invention may have not only greater sinterability, stability, and reliability but also more attractive magnetostriction properties than conventional magnetostrictive materials, thereby being suitable for use not only in
actuators for precision machining but also in motors, speakers, dumpers, sonars, and the like. Particularly, such alloys exhibit practically acceptable magnetostriction at cryogenic temperatures including liquid nitrogen temperature and can be thermally stable as well, thereby being applicable to various devices formed in combination with a superconductive coil such as switching actuators.

The fact that the present alloys can easily and reliably produce a predetermined magnetostriction in a low magnetic field such as 0.2-0.5 T (2-5 kOe) not only contributes to reducing the size of the device body and peripherals but also allowing their drive sources to be of compact design and drive forces can be reduced, thus providing a number of practical advantages.

**Claims**

1. A cobalt-iron magnetostrictive alloy comprising a composition containing iron, cobalt and at least one group 3 (IUPAC recommended notation since 1986) element, characterized in that said composition is represented by the general formula (I), in atomic proportion:

$$R (Co_{1-x}Fe_x)_z \qquad (I)$$

wherein:

$0.001 \leqq x \leqq 0.8$;

$0.2 \leqq z \leqq 15$, and

R is at least one of the following elements :

Sc, Y, La, Ce, Pr, Nd, Pm, Sm, Eu, Gd, Tb, Dy, Ho, Er, Tm, Yb, and Lu and the alloy consists essentially of a cubic system whose easy axis of magnetization is generally <100> or <110> oriented.

2. An alloy according to claim 1 wherein z = 2, z = 23/6, or z = 13.

3. An alloy according to claim 1 or 2 wherein $0.2 \leqq z \leqq 10$.

4. An alloy according to any preceding claim wherein $1.5 \leqq z \leqq 5$.

5. An alloy according to any preceding claim wherein R is at least one of Dy and Gd.

6. An alloy according to claim 5 wherein R comprises both Dy and Gd in amounts which satisfy the relation $(Dy_{1-s}Gd_s)$ wherein $s \leqq 0.5$.

7. An alloy according to any preceding claim wherein when normalized by the magnetostriction value of $DyFe_2$ at room temperature, the magnetostriction value, in a magnetic field of 0.2 Tesla (2kOe), is 10 or more at liquid nitrogen temperature.

8. An alloy according to any preceding claim wherein the amount of impurities such as $O_2$, and/or N, and/or Ca is in the range 10ppm to 1000ppm.

9. Use of an alloy as claimed in any preceding claim in fine displacement control drive means.

10. An instrument, machine, or device which includes at least one component which incorporates an alloy as claimed in any one of claims 1 to 8 as a functional part thereof.

**Patentansprüche**

1. Magnetostriktive Kobalt/Eisen-Legierung, die eine Zusammensetzung umfaßt, die Eisen, Kobalt und mindestens ein Element der Gruppe 3 (seit 1986 empfohlene IUPAC-Bezeichnung) enthält, dadurch gekennzeichnet, daß die Zusammensetzung durch die allgemeine Formel (I) in atomaren Anteilen dargestellt ist:

$$R(Co_{1-x}Fe_x)_z \qquad (I),$$

in der

$0,001 \leqq x \leqq 0,8$ ist,

$0,2 \leqq z \leqq 15$ ist und

R mindestens eines der folgenden Elemente ist:

Sc, Y, La, Ce, Pr, Nd, Pm, Sm, Eu, Gd, Tb, Dy, Ho, Er, Tm, Yb und Lu, und die Legierung im wesentlichen aus einem kubischen System besteht, dessen Easy-Achse der Magnetisierung im allgemeinen <100> oder <110> orientiert ist.

2. Legierung nach Anspruch 1, bei der z = 2 ist, z = 23/6 ist oder z = 13 ist.

3. Legierung nach Anspruch 1 oder 2, bei der $0,2 \leqq z \leqq 10$ ist.

4. Legierung nach einem der vorhergehenden Ansprüche, bei der $1,5 \leqq z \leqq 5$ ist.

5. Legierung nach einem der vorhergehenden Ansprüche, bei der R mindestens eines von Dy und Gd ist.

6. Legierung nach Anspruch 5, bei der R sowohl Dy als auch Gd in Mengen umfaßt, die die Beziehung $(Dy_{1-s}Gd_s)$

erfüllen, in der s $\leqq$ 0,5 ist.

7. Legierung nach einem der vorhergehenden Ansprüche, bei der der Magnetostriktionswert in einem magnetischen Feld von 0,2 Tesla (2kOe) bei der Temperatur von flüssigem Stickstoff 10 oder größer ist, wenn auf den Magnetostriktionswert von DyFe$_2$ bei Raumtemperatur normalisiert ist.

8. Legierung nach einem der vorhergehenden Ansprüche, bei der die Menge an Verunreinigungen wie O$_2$ und/oder N und/oder Ca im Bereich von 10 ppm bis 1000 ppm liegt.

9. Verwendung einer Legierung gemäß einem der vorhergehenden Ansprüche in Feinverschiebungskontrollantriebsmitteln.

10. Instrument, Maschine oder Vorrichtung, die mindestens eine Komponente enthält, die eine Legierung gemäß einem der Ansprüche 1 bis 8 als funktionellen Teil davon umfaßt.

**Revendications**

1. Alliage magnétostrictif à base de fer et de cobalt, qui comprend une composition contenant du fer, du cobalt et, au moins un élément du groupe 3 (notation recommandée par la IUPAC depuis 1986), caractérisé en ce que ladite composition est représentée par la forme générale (I) suivante, en proportions atomiques :
$$R\,(Co_{1-x}Fe_x)_z \qquad (I)$$
dans laquelle :
$0,001 \leqq x \leqq 0,8$
$0,2 \leqq z \leqq 15$, et
où R désigne l'un, au moins, des éléments suivants :
Sc, Y, La, Ce, Pr, Nd, Pm, Sm, Eu, Gd, Tb, Dy, Ho, Er, Tm, Yb et Lu, ledit alliage faisant essentiellement partie d'un système cubique dont l'axe de magnétisation aisé est généralement orienté dans la direction <100> ou <110>.

2. Alliage selon la revendication 1, caractérisé en ce que z = 23/6 ou z = 13.

3. Alliage selon la revendication 1 ou 2, caractérisé en ce que $0,2 \leqq z \leqq 10$.

4. Alliage selon l'une quelconque des revendications précédentes, caractérisé en ce que $1,5 \leqq z \leqq 5$.

5. Alliage selon l'une quelconque des revendications précédentes, caractérisé en ce que R représente, au moins, Dy et/Gd.

6. Alliage selon la revendication 5 où : R comprend à la fois Dy et Gd dans des quantités qui satisfont la relation suivante : $(Dy_{1-s}Gd_s)$ où $s \leqq 0,5$.

7. Alliage selon l'une quelconque des revendications précédentes, caractérisé en ce que, après normalisation par la valeur de la magnétostriction de DyFe$_2$, à la température ambiante, la valeur de la magnétostriction, dans un champ magnétique de 0,2 Tesla (2k0e) est égale ou supérieure à 10, à la température de l'azote liquide.

8. Alliage selon l'une quelconque des revendications précédentes, caractérisé en ce que la quantité d'impuretés telles que O$_2$ et/ou N, et/ou Ca est de l'ordre de 10ppm à 1000ppm.

9. Utilisation d'un alliage tel que celui revendiqué dans l'une quelconque des revendications précédentes dans des moyens d'actionnement de commandes de déplacements de haute précision.

10. Instrument, machine ou dispositif quelconque qui comporte, au moins, un composant renfermant un alliage tel que spécifié dans l'une quelconque des revendications 1 à 8, en tant que composant fonctionnel.

# F I G. I